(19) Europäisches Patentamt
European Patent Office
Office européen des brevets

(11) EP 4 489 308 A1

(12) EUROPEAN PATENT APPLICATION
published in accordance with Art. 153(4) EPC

(43) Date of publication:
08.01.2025 Bulletin 2025/02

(51) International Patent Classification (IPC):
H03M 1/08 (2006.01)    H03M 3/02 (2006.01)

(21) Application number: 22929804.7

(22) Date of filing: 03.03.2022

(52) Cooperative Patent Classification (CPC):
H03M 1/08; H03M 3/02

(86) International application number:
PCT/JP2022/009122

(87) International publication number:
WO 2023/166659 (07.09.2023 Gazette 2023/36)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: MITSUBISHI ELECTRIC
CORPORATION
Chiyoda-ku
Tokyo 100-8310 (JP)

(72) Inventors:
• OJIKA, Satoshi
  Tokyo 100-8310 (JP)
• OISHI, Masayuki
  Tokyo 100-8310 (JP)
• IWABUKI, Hiroyasu
  Tokyo 100-8310 (JP)

(74) Representative: Meissner Bolte Partnerschaft
mbB
Patentanwälte Rechtsanwälte
Postfach 86 06 24
81633 München (DE)

(54) **ANALOG-TO-DIGITAL CONVERTER, ANALOG-TO-DIGITAL CONVERSION SYSTEM, DIGITAL CONTROL DEVICE, AND DIGITAL CONTROL POWER SOURCE**

(57) In an analog/digital converter (90), a first integration circuit (10) temporally integrates a sum of an analog input signal (Vin) and a first feedback signal (V4) and includes an active element. A second integration circuit (20) temporally integrates a sum of a result of integration by the first integration circuit (10) and the first feedback signal (V4) and does not include an active element. A first signal generation circuit (34) compares a first output voltage (V5) representing a result of integration by the second integration circuit (20) with a threshold voltage (Vth) at discrete time intervals. When the first output voltage (V5) is higher than the threshold voltage (Vth), the first signal generation circuit (34) generates 1 as a first digital signal (DS), and when the first output voltage (V5) is lower than the threshold voltage (Vth), the first signal generation circuit (34) generates 0 as the first digital signal (DS). The first signal generation circuit (34) outputs a signal obtained by inverting 1 and 0 of the first digital signal (DS) as the first feedback signal (V4).

FIG.1

EP 4 489 308 A1

**Description**

TECHNICAL FIELD

The present disclosure relates to an analog/digital converter, an analog/digital conversion system, a digital control device, and a digital control power supply.

BACKGROUND ART

A technique disclosed, for example, in Japanese Patent Laying-Open No.2019-057937 (PTL 1) has been known as a technique to enhance conversion accuracy with an inexpensive circuit configuration in a $\Delta\Sigma$ type analog/digital (A/D) converter.

In the $\Delta\Sigma$ type A/D converter described in this literature, a $\Delta\Sigma$ modulation unit includes a first $\Delta\Sigma$ modulation unit an input voltage to which has a voltage value of a voltage to be inspected and a second $\Delta\Sigma$ modulation unit an input voltage to which has a voltage value of a correction reference voltage. A digital filter unit is provided with a first digital filter to generate N-bit data based on information indicated by 1-bit data generated by the first $\Delta\Sigma$ modulation unit and a second digital filter to generate N-bit data based on information indicated by 1-bit data generated by the second $\Delta\Sigma$ modulation unit. A correction computing unit performs correction computation of the N-bit data created by the first digital filter with the N-bit data created by the second digital filter (see the Abstract of PTL 1). In the $\Delta\Sigma$ modulation unit, a resistive element R1 and a capacitor C1 perform a function of a smoothing circuit, a function of a delay DA conversion circuit, and a function of an integration circuit (see paragraphs [0018] and [0019] of PTL 1).

CITATION LIST

PATENT LITERATURE

PTL 1: Japanese Patent Laying-Open No. 2019-057937

SUMMARY OF INVENTION

TECHNICAL PROBLEM

According to a configuration of the $\Delta\Sigma$ type A/D converter disclosed in Japanese Patent Laying-Open No. 2019-057937 (PTL 1) above, compensation for an error due to insufficient accuracy of the reference voltage value is expected to inexpensively be made. Reduction in quantization error caused in conversion of an analog signal into a digital signal, however, is not particularly taken into consideration.

The present disclosure was made in view of the background art above, and one of objects thereof is to provide a $\Delta\Sigma$ type A/D converter capable of achieving conversion accuracy higher than in a conventional technique with an inexpensive circuit configuration. Other objects and features of the present disclosure will be described in embodiments below.

SOLUTION TO PROBLEM

An analog/digital converter in one embodiment includes a first integration circuit, a second integration circuit, and a first signal generation circuit. The first integration circuit temporally integrates a sum of an analog input signal and a first feedback signal and includes an active element. The second integration circuit temporally integrates a sum of a result of integration by the first integration circuit and the first feedback signal and does not include an active element. The first signal generation circuit compares a first output voltage representing a result of integration by the second integration circuit with a threshold voltage at discrete time intervals. The first signal generation circuit generates 1 as a first digital signal when the first output voltage is higher than the threshold voltage and generates 0 as the first digital signal when the first output voltage is lower than the threshold voltage. The first signal generation circuit outputs a signal obtained by inversion of 1 and 0 of the first digital signal as the first feedback signal.

ADVANTAGEOUS EFFECTS OF INVENTION

According to the embodiment above, a secondary $\Delta\Sigma$ type analog/digital converter can be configured with the first integration circuit including the active element and the second integration circuit not including the active element, and hence conversion accuracy can be higher than in the conventional technique with an inexpensive circuit configuration.

BRIEF DESCRIPTION OF DRAWINGS

Fig. 1 is a circuit diagram showing a configuration of a $\Delta\Sigma$ type A/D converter 90 according to a first embodiment.
Fig. 2 is a functional block diagram of a secondary $\Delta\Sigma$ modulator 300 corresponding to $\Delta\Sigma$ type A/D converter 90 in Fig. 1.
Fig. 3 is a circuit diagram showing a configuration of a $\Delta\Sigma$ type A/D converter 92 according to a second embodiment.
Fig. 4 is a circuit diagram showing an exemplary configuration of an A/D conversion system 93 according to a third embodiment.
Fig. 5 is a circuit diagram showing a configuration of a digital control device 201 and a digital control power supply 200 including A/D conversion system 93 in Fig. 4.

DESCRIPTION OF EMBODIMENTS

Each embodiment will be described in detail below with reference to the drawings. The same or corresponding elements have the same reference characters allotted and description thereof will not be repeated.

First Embodiment.

[Configuration of ΔΣ Type A/D Converter]

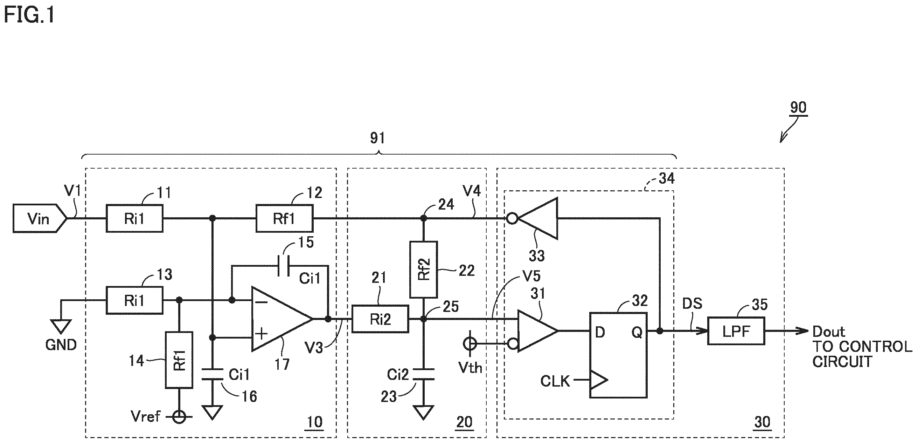

Fig. 1 is a circuit diagram showing a configuration of a ΔΣ type A/D converter 90 according to a first embodiment. ΔΣ type A/D converter 90 according to the first embodiment includes an analog circuit portion (10 and 20) and a digital circuit 30. The analog circuit portion (10 and 20) includes an integration circuit 10 including an active element and an integration circuit 20 configured with a passive circuit and not including an active element. The active element refers to a semiconductor amplifier and the like configured with an operational amplifier or a discrete component. Integration circuit 10 will also be referred to as an active integration circuit 10 or a first integration circuit 10 below and integration circuit 20 will also be referred to as a passive integration circuit 20 or a second integration circuit 20 below. A configuration of each of circuits 10 to 30 and connection between constituent elements included in each circuit will initially be described.

Active integration circuit 10 is configured to temporally integrate a sum of an input signal Vin and a digital signal fed back from digital circuit 30 to active integration circuit 10. As shown in Fig. 1, active integration circuit 10 includes resistive elements 11 to 14, capacitors 15 and 16, and a semiconductor amplifier 17. Semiconductor amplifier 17 is an operational amplifier including a non-inverting input terminal (a + terminal), an inverting input terminal (a - terminal), and an output terminal.

Resistive element 11 is connected between a node to which input signal Vin is inputted and the non-inverting input terminal of semiconductor amplifier 17. Resistive element 12 is connected between a node 24 on an output side of a buffer element 33 which will be described later and the non-inverting input terminal of semiconductor amplifier 17. Capacitor 16 is connected between the non-inverting input terminal of semiconductor amplifier 17 and a ground GND. Resistive element 13 is connected between the inverting input terminal of semiconductor amplifier 17 and ground GND. Resistive element 14 is connected between the inverting input terminal of semiconductor amplifier 17 and a node to which a reference voltage Vref is supplied. Capacitor 15 is connected between the inverting input terminal and the output terminal of semiconductor amplifier 17.

Passive integration circuit 20 is configured to temporally integrate a sum of the output signal from active integration circuit 10 and a digital signal fed back from digital circuit 30 to passive integration circuit 20. As shown in Fig. 1, passive integration circuit 20 includes resistive elements 21 and 22 and a capacitor 23. Resistive element 22 and capacitor 23 are connected in series in this order between node 24 on the output side of buffer element 33 and ground GND. Resistive element 21 is connected between the output terminal of semiconductor amplifier 17 of active integration circuit 10 and a connection node 25 between resistive element 22 and capacitor 23.

Digital circuit 30 compares an output voltage V5 from passive integration circuit 20 with a threshold voltage Vth at discrete time intervals (specifically, every cycle of a clock signal CLK). When output voltage V5 is higher than threshold voltage Vth, digital circuit 30 feeds a digital signal "0" back to analog circuit portions 10 and 20, and when output voltage V5 is lower than threshold voltage Vth, digital circuit 30 feeds a digital signal "1" back to analog circuit portions 10 and 20. Digital circuit 30 may be configured to feed "0" or "1" back when output voltage V5 is equal to threshold voltage Vth. As shown in Fig. 1, digital circuit 30 includes a differential input buffer element 31, a D flip-flop 32, buffer element 33 for inverted output, and a low pass filter (LPF) 35.

Buffer element 31 has a non-inverting input terminal connected to connection node 25 of passive integration circuit 20. Threshold voltage Vth is inputted to an inverting input terminal of buffer element 31. An output signal from buffer element 31 is inputted to a D terminal of D flip-flop 32. A digital signal DS outputted from a Q terminal of D flip-flop 32 is inputted to low pass filter 35 and to buffer element 33. Clock signal CLK is inputted to a clock terminal of D flip-flop 32. Buffer element 33 outputs a signal obtained by inversion of 0/1 of inputted digital signal DS to one end of resistive element 12 and one end of resistive element 22.

In the present disclosure, buffer elements 31 and 33 and D flip-flop 32 are collectively referred to as a signal generation circuit 34. Signal generation circuit 34 generates digital signal DS in accordance with input signal Vin and outputs a signal obtained by inversion of 0/1 of digital signal DS as a feedback signal to active integration circuit 10 and passive integration circuit 20. Active integration circuit 10, passive integration circuit 20, and signal generation circuit 34 implement what is called a ΔΣ modulator 91.

Low pass filter 35 removes quantization noise shifted into a high frequency domain by a noise shaping function of ΔΣ modulator 91. Consequently, a highly accurate digital signal Dout in proportion to analog input signal Vin is outputted from ΔΣ type A/D converter 90. Instead of the low pass filter, processing for counting a ratio of 0 or 1 in digital signal DS outputted from signal generation circuit 34 may be performed.

Digital circuit 30 can also be configured with an individual semiconductor element, or with a programmable logic device or a microprocessor. In particular, a field programmable gate array (FPGA) which is one type of the programmable logic device often includes a differential input buffer, and it is suitable for highly integrated mount of a large number of A/D conversion circuits and other digital circuits.

When reference voltage Vref is set to be equal to a supply voltage of buffer element 33 in Fig. 1, this voltage serves as the reference voltage of the A/D converter. In addition, when threshold voltage Vth is set to 1/2 of reference voltage Vref, circuit operations are suitably symmetrical.

[Operation of ΔΣ Type A/D Converter]

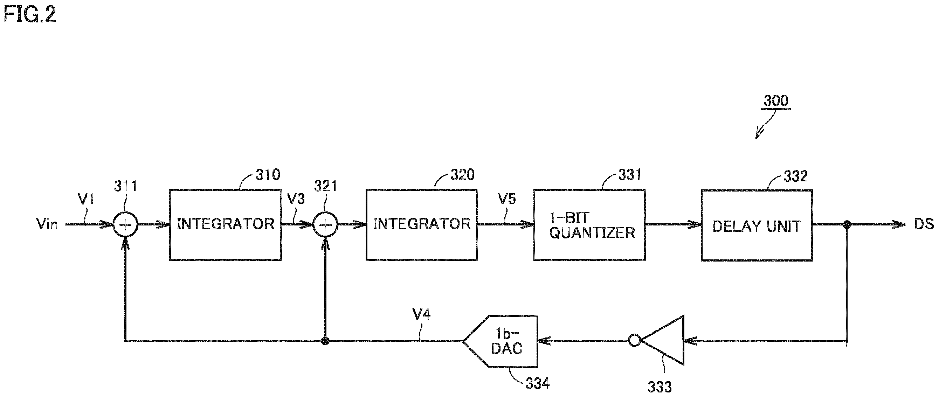

An operation of ΔΣ type A/D converter 90 will now be described. Fig. 2 is a functional block diagram of a secondary ΔΣ modulator 300 corresponding to ΔΣ type A/D converter 90 in Fig. 1.

As shown in Fig. 2, ΔΣ modulator 300 includes integrators 310 and 320, adders 311 and 321, a 1-bit quantizer 331, a delay unit 332, a buffer element 333 for inverted output, and a 1-bit digital-to-analog converter (DAC) 334. In an example where buffer element 333 for inverted output is not provided in a stage immediately subsequent to delay unit 332, a subtractor should be provided instead of each of adders 311 and 321. The present embodiment is characterized in that an adder can be employed instead of a subtractor, by providing buffer element 333.

An operation in Fig. 2 will briefly be described. Adder 311 adds a feedback signal V4 to input signal Vin (an input voltage V1). Integrator 310 temporally integrates results of addition by adder 311. Adder 321 adds feedback signal V4 to a voltage V3 representing a result of integration by integrator 310. Integrator 320 temporally integrates results of addition by adder 321. One-bit quantizer 331 compares voltage V5 representing a result of integration by integrator 320 with threshold voltage Vth to convert the voltage into a binary digital signal. Delay unit 332 generates digital signal DS by delaying an output from 1-bit quantizer 331 by one clock cycle. Buffer element 333 inverts 0/1 of digital signal DS outputted from delay unit 332. Digital/analog converter 334 generates feedback signal V4 by converting the inverted digital signal outputted from buffer element 333 into an analog signal.

Each functional block in Fig. 2 is associated with the circuit in Fig. 1 as below. Initially, adder 311 and integrator 310 in Fig. 2 correspond to active integration circuit 10 in Fig. 1. Adder 321 and integrator 320 in Fig. 2 correspond to passive integration circuit 20 in Fig. 1. One-bit quantizer 331 in Fig. 2 corresponds to differential input buffer element 31 in Fig. 1. Delay unit 332 in Fig. 2 corresponds to D flip-flop 32 in Fig. 1. Buffer element 333 and digital/analog converter 334 in Fig. 2 correspond to buffer element 33 in Fig. 1.

The digital signal "0" is defined as a Low level and the digital signal "1" is defined as a High level. A negative feedback circuit necessary for ΔΣ type A/D converter 90 can thus be configured without a subtractor, and simplified passive integration circuit 20 can be employed for integrator 320 in a second stage. Though the digital signal "0" fed back from digital circuit 30 may be defined as the High level and the digital signal "1" may be defined as the Low level, analog circuit portions 10 and 20 should perform a subtraction function in that case.

Operations of active integration circuit 10 and passive integration circuit 20 in Fig. 1 will be described in detail below. In active integration circuit 10, resistance values of resistive elements 11 and 13 are denoted as Ri1, resistance values of resistive elements 12 and 14 are denoted as Rf1, and capacitance values of capacitors 15 and 16 are denoted as Ci1. With

$$V2 = V4 - Vref \qquad ... (1),$$

a transfer function of active integration circuit 10 is represented as below, based on a condition of virtual short of the operational amplifier implemented by semiconductor amplifier 17 and the input current being 0:

$$(V1/Ri1 + V2/Rf1)/(s \bullet Ci1) \qquad ... (2).$$

In other words, in active integration circuit 10, the sum of a constant multiple of input voltage V1 and a constant multiple of a feedback voltage V2 is integrated.

When input voltage V1 is in a direct-current (DC) steady state, an output from active integration circuit 10 has some constant value. In this case, since an input to active integration circuit 10 is 0 because of differentiation of the output, relation below is satisfied.

$$V1/Ri1 + V2/Rf1 = 0 \qquad ... (3)$$

With an expression (3) above, it can be seen that a range of input voltage V1 can be set based on a ratio of gain resistances Ri1 and Rf1 in active integration circuit 10. For example, when reference voltage Vref is equal to the supply voltage of buffer element 33 in Fig. 1, an output voltage V4 from buffer element 33 is reference voltage Vref or 0. Therefore, voltage V2 expressed in the expression (1) above is 0 or -Vref. By substituting this value of voltage V2 into the expression (3) above, a lower limit value of input voltage V1 is 0 V and an upper limit value of input voltage V1 is Vref×Ri1/Rf1.

Since an offset voltage can be increased or decreased by changing connection of a resistor as in the case of a general differential amplification circuit, the lower limit value of input voltage V1 is not limited to 0 V. For example, a negative voltage can also be inputted as input voltage V1.

Similarly, in passive integration circuit 20 in Fig. 1, a resistance value of resistive element 21 is denoted as Ri2, a resistance value of resistive element 22 is denoted as Rf2, and a capacitance value of capacitor 23 is denoted as Ci2. In this case, a transfer function of passive integration circuit 20 is expressed in an expression below:

$$(V3/Ri2+V4/Rf2)/(s \cdot Ci2) \qquad ... (4).$$

In other words, in passive integration circuit 20, a sum of a constant multiple of output voltage V3 from active integration circuit 10 and a constant multiple of feedback voltage V4 is integrated.

Since passive integration circuit 20 is an RC integration circuit, it can be regarded as an integrator only in a region where variation in output voltage V5 therefrom is less. Therefore, a time constant of Rf2•Ci2 is set to sufficiently be larger than time of delay (that is, the clock cycle) by delay unit 332. Variation in voltage of capacitor 23 is thus suppressed and only a passive element implements the integrator.

In the steady state, the output from passive integration circuit 20 is kept at a constant value (that is, threshold voltage Vth). In this case, since the input to passive integration circuit 20 is 0 because of differentiation of the output, relation below is satisfied.

$$(V3-Vth)/Ri2+(V4-Vth)/Rf2 = 0 \qquad ... (5)$$

With an expression (5) above, it can be seen that a range of input voltage V3 can be set based on a ratio of gain resistances Ri2 and Rf2 in passive integration circuit 20. For example, when reference voltage Vref is equal to the supply voltage of buffer element 33 in the circuit in Fig. 1, output voltage V4 from buffer element 33 is reference voltage Vref or 0. By substituting this voltage V4 into the expression (4) above, the lower limit value of input voltage V3 is Vth-(Vref-Vth)×Ri2/Rf2 and the upper limit value of input voltage V3 is Vth×(1+Ri2/Rf2). Thus, a range of input to passive integration circuit 20 can be set in accordance with output characteristics of semiconductor amplifier 17 included in active integration circuit 10.

D flip-flop 32 in Fig. 1 outputs digital signal DS, a ratio of 0/1 of which is varied with analog input signal Vin. Specifically, in the circuit configuration in Fig. 1, when voltage V1 of analog input signal Vin is equal to or lower than 0 V, D flip-flop 32 always outputs 0, and a frequency of output of 1 becomes higher in proportion to voltage V1 of analog input signal Vin.

[Effect in First Embodiment]

As set forth above, according to the first embodiment, only a single analog semiconductor amplifier as an active component of the analog circuit portion can implement secondary ΔΣ type A/D converter 90. Therefore, a highly accurate A/D conversion circuit can be provided with low cost with the use of general-purpose components.

Second Embodiment.

In a second embodiment, a ΔΣ type A/D converter 92 enhanced in reliability by addition of a failure sensing function to ΔΣ type A/D converter 90 in the first embodiment will be described.

[Configuration of ΔΣ Type A/D Converter]

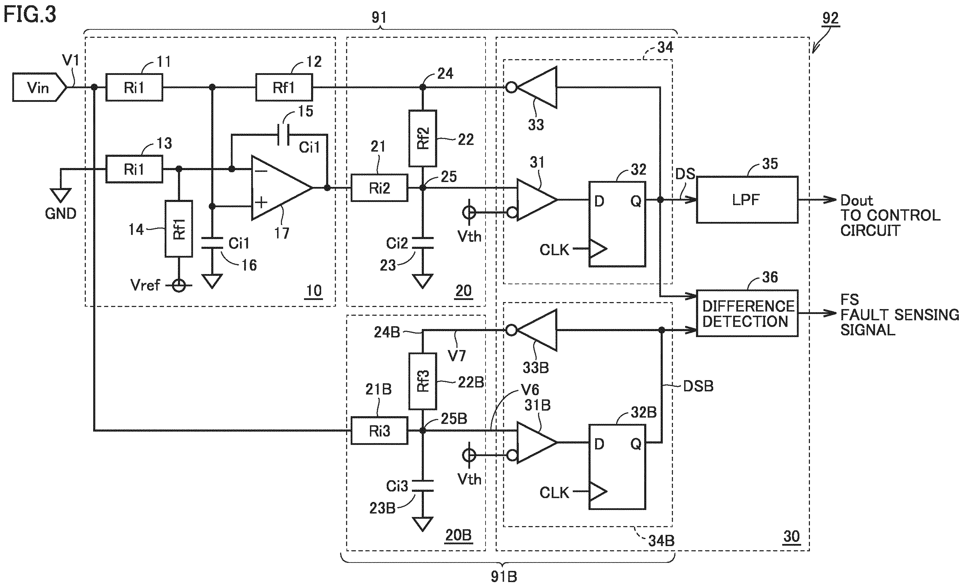

Fig. 3 is a circuit diagram showing a configuration of ΔΣ type A/D converter 92 according to the second embodiment. ΔΣ type A/D converter 92 in Fig. 3 is different from ΔΣ type A/D converter 90 in Fig. 1 in that it further includes a second passive integration circuit 20B and digital circuit 30 further includes a second signal generation circuit 34B and a difference detection circuit 36.

Second passive integration circuit 20B is an integration circuit similar in configuration to passive integration circuit 20 described with reference to Fig. 1, the integration circuit being configured with a passive circuit and not including an active element. Second passive integration circuit 20B is configured to temporally integrate a sum of input signal Vin and a digital signal (that is, a feedback voltage V7) outputted from second signal generation circuit 34B of digital circuit 30. In the present disclosure, second passive integration circuit 20B is also referred to as a third integration circuit.

More specifically, second passive integration circuit 20B includes resistive elements 21B and 22B and a capacitor 23B. Resistive element 22B and capacitor 23B are connected in series in this order between a node 24B on an output side of a buffer element 33B which will be described later and ground GND. Resistive element 21B is connected between a node to which input signal Vin is inputted and a connection node 25B between resistive element 22B and capacitor 23B.

Second signal generation circuit 34B of digital circuit 30 compares an output voltage V6 from second passive integration circuit 20B with threshold voltage Vth at discrete time intervals (specifically, every cycle of clock signal CLK). When output voltage V6 is higher than threshold voltage Vth, second signal generation circuit 34B feeds the digital signal "0" back to second passive integration circuit 20B, and when output voltage V6 is equal to or lower than threshold voltage Vth, second signal generation circuit 34B feeds the digital signal "1" (that is, feedback voltage V7) back to second passive integration circuit 20B. Note that digital circuit 30 may be configured to feed back any of "0" or "1" when output voltage V6 is equal to threshold voltage Vth.

More specifically, similarly to signal generation circuit 34 described with reference to Fig. 1, second signal generation circuit 34B includes a differential input buffer element 31B, a D flip-flop 32B, and buffer element 33B for inverted output. Buffer element 31B has a non-inverting input terminal connected to connection node 25B of second passive integration circuit 20B. Threshold voltage Vth is inputted to an inverting input terminal of buffer element 31B. An output signal from buffer element 31B is inputted to a D terminal of D flip-flop 32B. A digital signal DSB outputted from a Q terminal of D flip-flop 32B is inputted to difference detection circuit 36 and to buffer element 33B. Clock signal CLK is inputted to a clock terminal of D flip-flop 32B. Buffer element 33B outputs a signal obtained by inversion (feedback voltage V7) of inputted digital signal DSB to one end of resistive element 22B.

When reference voltage Vref is set to be equal to a supply voltage of buffer element 33B, this voltage serves as a reference voltage of a primary $\Delta\Sigma$ modulator 91B configured with second passive integration circuit 20B and second signal generation circuit 34B. In addition, when threshold voltage Vth is set to Vref/2, circuit operations are suitably symmetrical.

The digital signal "0" is defined as the Low level and the digital signal "1" is defined as the High level. A negative feedback circuit necessary for primary $\Delta\Sigma$ type modulator 91B can thus be configured without a subtractor, and simplified passive integration circuit 20 can be employed. Though the digital signal "0" fed back from second signal generation circuit 34B of digital circuit 30 may be defined as the High level and the digital signal "1" may be defined as the Low level, second passive integration circuit 20B should perform a subtraction function in that case.

Difference detection circuit 36 receives digital signal DS outputted from D flip-flop 32 of signal generation circuit 34 and digital signal DSB outputted from D flip-flop 32B of second signal generation circuit 34B. When a difference between a time average of digital signal DS and a time average of digital signal DSB becomes equal to or larger than a certain threshold value, signal generation circuit 34 outputs a fault sensing signal FS.

As in the first embodiment, digital circuit 30 in Fig. 3 can also be configured with an individual semiconductor element, or with a programmable logic device or a microprocessor. In particular, an FPGA which is one type of the programmable logic device often includes a differential input buffer, and it is suitable for highly integrated mount of a large number of A/D conversion circuits and other digital circuits.

Since Fig. 3 is otherwise similar in configuration to Fig. 1, the same or corresponding elements have the same reference numerals allotted and description will not be repeated.

[Operation of $\Delta\Sigma$ Type A/D Converter]

An operation of $\Delta\Sigma$ type A/D converter 92 in Fig. 3 will now be described. Initially, since operations of secondary $\Delta\Sigma$ modulator 91 configured with active integration circuit 10, passive integration circuit 20, and signal generation circuit 34 in Fig. 3 are as described above in the first embodiment, detailed description will not be repeated. Digital signal DS, the ratio of 0/1 of which is varied with analog input signal Vin, is obtained from D flip-flop 32 of signal generation circuit 34. Specifically, in the circuit configuration in Fig. 3, when voltage V1 of analog input signal Vin is equal to or lower than 0 V, D flip-flop 32 always outputs 0, and a frequency of output of 1 from D flip-flop 32 becomes higher in proportion to voltage V1 of analog input signal Vin.

Primary $\Delta\Sigma$ modulator 91B is configured with second passive integration circuit 20B and second signal generation circuit 34B in Fig. 3 that are newly added. In second passive integration circuit 20B, a resistance value of resistive element 21B is denoted as Ri3, a resistance value of resistive element 22B is denoted as Rf3, and a capacitance value of capacitor 23B is denoted as Ci3. In this case, a transfer function of second passive integration circuit 20B is expressed as below.

$$(V1/Ri2+V7/Rf2)/(s \bullet Ci3) \quad ... (6)$$

In other words, in second passive integration circuit 20B, a sum of a constant multiple of input voltage V1 and a constant multiple of feedback voltage V7 is integrated.

Since second passive integration circuit 20B is an RC integration circuit, it can be regarded as an integrator only in a region where variation in output voltage V6 therefrom is less. Therefore, a time constant of Rf3•Ci3 is set to sufficiently be larger than time of delay (that is, the clock cycle) by the delay unit. Variation in voltage in capacitor 23B is thus suppressed and only a passive element implements the integrator.

In the steady state, the output from second passive integration circuit 20B is kept at a constant value (that is, threshold voltage Vth). In this case, since the input to second passive integration circuit 20B is 0 because of differentiation of the output, relation below is satisfied.

$$(V1-Vth)/Ri3+(V7-Vth)/Rf3 = 0 \quad ... (7)$$

With an expression (7) above, it can be seen that a range of input voltage V1 can be set based on a ratio of gain resistances Ri3 and Rf3 in second passive integration circuit 20B. For example, when reference voltage Vref is equal to the supply voltage of buffer element 33B in the circuit in Fig. 3, output voltage V7 from buffer element 33B is reference voltage Vref or 0. By substituting this voltage V7 into the expression (7) above, the lower limit value of input voltage V1 is Vth-(Vref-Vth)×Ri3/Rf3 and the upper limit value of input voltage V1 is Vth×(1+Ri3/Rf3). A range of input to second passive integration circuit 20B can therefore be set in accordance with the range of input to active integration circuit 10 based on the ratio of gain resistances Ri3 and Rf3.

D flip-flop 32B of second signal generation circuit 34B outputs digital signal DSB, a ratio of 0/1 of which is varied with input signal Vin. Specifically, in the circuit configuration in Fig. 3, when the voltage of analog input signal Vin is equal to or lower than Vth-(Vref-Vth)×Ri3/Rf3, D flip-flop 32B always outputs 0, and a frequency of output of 1 from D flip-flop 32B becomes higher in proportion to the voltage of analog input signal Vin.

First ΔΣ modulator 91 configured with active integration circuit 10, passive integration circuit 20, and signal generation circuit 34 and second ΔΣ modulator 91B configured with second passive integration circuit 20B and second signal generation circuit 34B are designed such that time average values of digital signals DS and DSB outputted in response to the same input signal Vin are equal to each other. Therefore, the input ranges thereof are also designed to be equal to each other. Though designs different in input range can also be made, in that case, difference detection circuit 36 corrects one of the time average of digital signal DS outputted from D flip-flop 32 and the time average of digital signal DSB outputted from D flip-flop 32B, with a linear function. The time averages of corrected digital signals DS and DSB in response to the same input signal Vin are thus equal to each other.

As described previously, when the difference between the time average of digital signal DS outputted from D flip-flop 32 and the time average of digital signal DSB outputted from D flip-flop 32B becomes equal to or larger than a certain threshold value, difference detection circuit 36 outputs fault sensing signal FS. Thus, when first ΔΣ modulator 91 fails, the difference between the time averages of digital signals DS and DSB becomes equal to or larger than the threshold value and fault sensing signal FS is outputted. Therefore, a control circuit in a subsequent stage can recognize that a result of A/D conversion is not reliable.

[Effect in Second Embodiment]

As set forth above, according to the second embodiment, only single analog semiconductor amplifier 17 as an active component of the analog circuit portion can implement secondary ΔΣ type A/D converter 92 with the failure sensing function. Therefore, a highly accurate and highly reliable A/D conversion circuit can be provided with low cost with the use of general-purpose components.

Third Embodiment.

In a third embodiment, an A/D conversion system 93 including a plurality of ΔΣ type A/D converters 92 in the second embodiment will be described. When an operating ΔΣ type A/D converter fails, A/D conversion system 93 can make switching to another ΔΣ type A/D converter. Furthermore, an example in which A/D conversion system 93 is applied to a digital control device 201 to control a power conversion circuit 60 will be described.

[Configuration of A/D Conversion System]

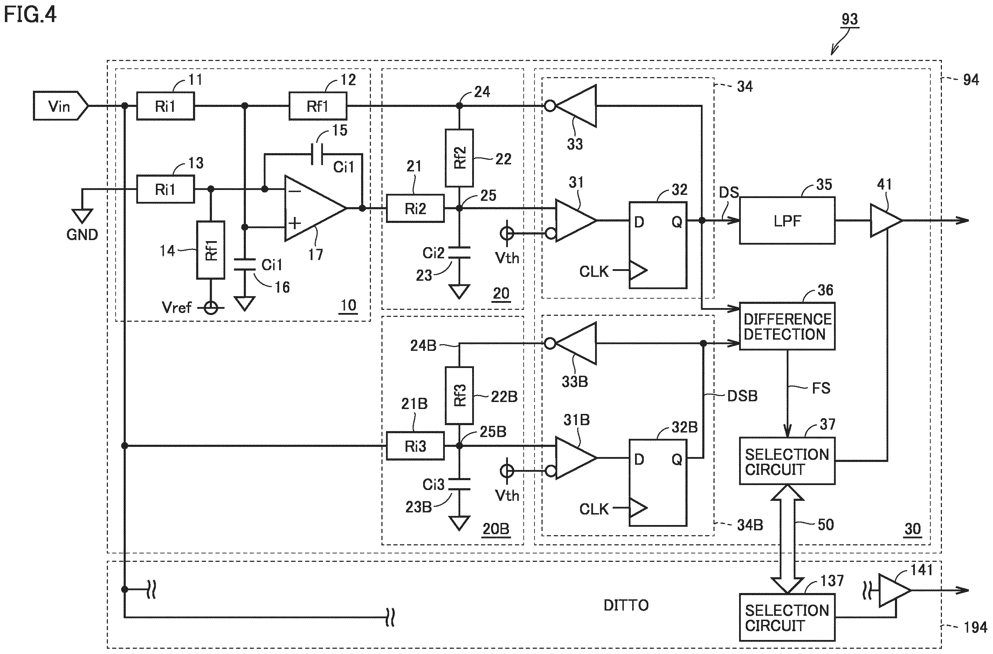

Fig. 4 is a circuit diagram showing an exemplary configuration of A/D conversion system 93 according to the third embodiment. A/D conversion system 93 in the third embodiment includes a plurality of ΔΣ type A/D converters similar in configuration to ΔΣ type A/D converter 92 in Fig. 3. Each ΔΣ type A/D converter receives common input signal Vin. A stand-by redundancy system is configured by including a plurality of A/D converters identical in configuration. An operating ΔΣ type A/D converter will hereinafter be called a main converter.

A/D conversion system 93 shown in Fig. 4 includes a first ΔΣ type A/D converter 94 and a second ΔΣ type A/D converter 194 by way of example. Digital circuit 30 of first ΔΣ type A/D converter 94 further includes a selection circuit 37 and a buffer element 41, and a digital circuit of second ΔΣ type A/D converter 194 further includes a selection circuit 137 and a buffer element 141. Selection circuit 37 of first ΔΣ type A/D converter 94 and selection circuit 137 of second ΔΣ type A/D converter 194 are connected to each other through a communication path 50. In the present disclosure, selection circuit 37 is also referred to as a first selection circuit and selection circuit 137 is also referred to as a second selection circuit.

Selection circuit 37 receives fault sensing signal FS from difference detection circuit 36. While first ΔΣ type A/D converter 94 is operating as the main converter, selection circuit 37 of first ΔΣ type A/D converter 94 transmits a signal indicating a normal operation to selection circuit 137 of second ΔΣ type A/D converter 194. When a power supply is abnormal, when a clock is abnormal, or while selection circuit 37 is receiving fault sensing signal FS from difference detection circuit 36, selection circuit 37 stops transmission of the signal indicating the normal operation. Selection circuit 37 can thus notify selection circuit 137 of a fault of first ΔΣ type A/D converter 94.

Selection circuit 137 of second ΔΣ type A/D converter 194 in stand-by monitors a normal operation signal outputted from selection circuit 37 of first ΔΣ type A/D converter 94 serving as the main converter. Selection circuit 137 performs a function to switch output of the digital signal which is a result of A/D conversion from another converter to the converter to which it belongs, on the occurrence of the fault when the normal operation signal cannot be received. In Fig. 4, selection circuit 37 of currently operating first ΔΣ type A/D converter 94 deactivates the output from buffer element 41 and selection circuit 137 of currently stand-by second ΔΣ type A/D converter 194 activates the output from buffer element 141. Though Fig. 4 shows an example in which selection circuits 37 and 137 control signals to activate outputs from buffer elements 41 and 141, a switching circuit such as a multiplexer or a selector instead of buffer elements 41 and 141 may be provided.

A pulsed signal or a serial communication signal rather than a level signal may be used as the normal operation signal outputted from selection circuits 37 and 137. In an example where the level signal is used, when a circuit element for communication or a communication path fails and a signal is fixed (that is, the signal does not change from a value indicating a normal state), the normal operation and an abnormal state cannot be distinguished from each other. In contrast, in an example where the pulsed signal or the serial communication signal is used as the normal operation signal, when the signal is fixed, a normal signal cannot be received and hence determination as the abnormal state can be made. Alternatively, when the serial communication signal is used, another type of information can also be superimposed thereon, which is further suitable.

[Configuration of Digital Control Power Supply and Digital Control Device]

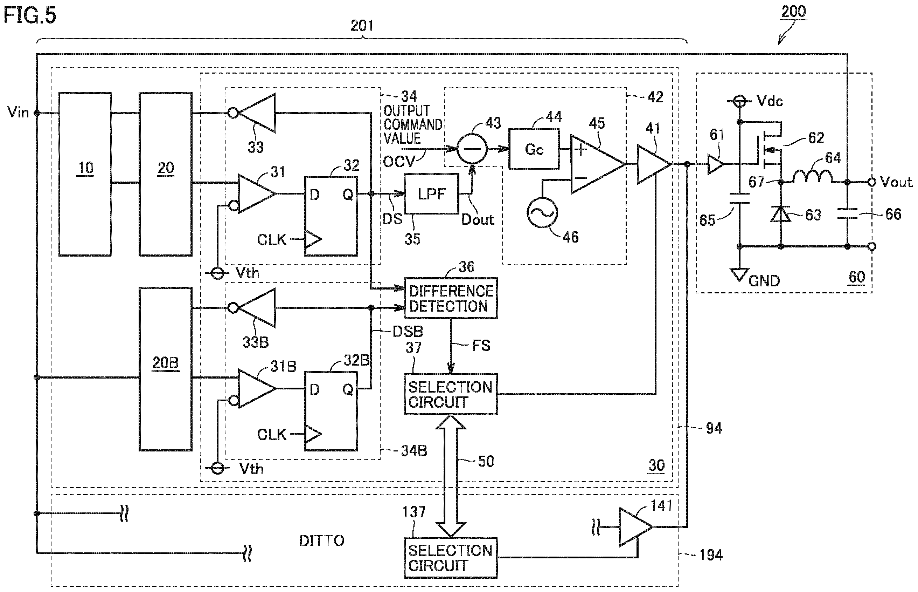

Fig. 5 is a circuit diagram showing a configuration of digital control device 201 and a digital control power supply 200 including A/D conversion system 93 in Fig. 4.

Referring to Fig. 5, digital control power supply 200 includes power conversion circuit 60 and digital control device 201 to control power conversion circuit 60. Digital control device 201 further includes a digital controller 42 in digital circuit 30 of each ΔΣ type A/D converter included in A/D conversion system 93 in Fig. 4. Digital controller 42 is a feedback control unit to perform pulse width modulation (PWM) by feedback control based on a result of A/D conversion. Buffer elements 41 and 141 are provided in a stage subsequent to digital controller 42.

Specifically, in the example shown in Fig. 5, digital controller 42 includes a subtractor 43, a compensator 44, a comparator 45, and a carrier wave oscillator 46. Operations of these constituent elements inclusive of low pass filter 35 will briefly be described below.

Low pass filter 35 generates a multi-bit digital value Dout from 1-bit digital signal DS subjected to ΔΣ modulation. Subtractor 43 compares digital value Dout with an output command value OCV to calculate a difference therebetween. Compensator 44 calculates a duty as an amount of operation by multiplying the difference calculated by subtractor 43 by an appropriate transfer function. Comparator 45 generates a PWM signal by comparing carrier waves generated by carrier wave oscillator 46 with the amount of operation. Buffer element 41 outputs a PMW signal generated by comparator 45 to power conversion circuit 60 in a subsequent stage while selection circuit 37 has activated the output.

Though Fig. 5 shows a general configuration for PWM by feedback control, a configuration that performs a similar function is available otherwise, and the configuration is not limited to that in Fig. 5.

Power conversion circuit 60 controls a voltage and/or a current by ON/OFF control of a power semiconductor element 62. A feedback loop is formed by returning an output voltage or an output current from power conversion circuit 60 as input signal Vin to the A/D conversion system. Thus, a switching regulator (digital control power supply 200) to output a desired voltage or current under digital control can be configured.

Fig. 5 shows a general step-down chopper (that is, a buck converter) circuit by way of example of power conversion circuit 60. Specifically, power conversion circuit 60 in Fig. 5 includes a buffer element 61, power semiconductor element 62, a diode 63, an inductor 64, an input capacitor 65, and an output capacitor 66.

As shown in Fig. 5, power semiconductor element 62 and inductor 64 are connected in this order between a power supply node to receive a DC voltage Vdc and an output node to provide output voltage Vout. Diode 63 has a cathode connected to a connection node 67 between power semiconductor element 62 and inductor 64 and has a cathode connected to ground GND. A PWM signal is inputted to a gate of power semiconductor element 62 through buffer element 61. Input capacitor 65 is connected between the power supply node and ground GND. Output capacitor 66 is connected between the output node and ground GND. Output voltage Vout is fed back to digital control device 201 as input signal Vin.

Power conversion circuit 60 is not limited to the step-down chopper in Fig. 5, and any power conversion circuit 60 can be used as being combined with digital control device 201.

[Effect in Third Embodiment and Modification]

As set forth above, according to the third embodiment, reliability can further be enhanced by constructing redundant A/D conversion system 93 including a plurality of ΔΣ type A/D converters 92 in the second embodiment. Furthermore, A/D conversion system 93 in the third embodiment can be applied to digital control device 201 and digital control power supply 200.

The configurations in the first to third embodiments are by way of example and are not limited, and the configurations incorporating existing known techniques can freely be combined for use. For example, the digital control power supply can be configured by combining digital controller 42 and power conversion circuit 60 in Fig. 5 with ΔΣ type A/D converter 90 in the first embodiment.

In configuring a highly reliable system, there is a concept of a single point of failure. The single point of failure refers to an element that causes loss of a function of the entire system by a single failure. By adopting ΔΣ type A/D converter 92 in the second embodiment or A/D conversion system 93 in the third embodiment in a signal path where a single point of failure may occur and adopting ΔΣ type A/D converter 90 in the first embodiment in a signal path where a single point of failure may not occur, a system for which resistance to failure is ensured as a whole can be realized at minimum cost.

It should be understood that the embodiments disclosed herein are illustrative and non-restrictive in every respect. The scope of this application is defined by the terms of the claims rather than the description above and is intended to include any modifications within the scope and meaning equivalent to the terms of the claims.

REFERENCE SIGNS LIST

10 active integration circuit (first integration circuit); 11 to 14, 21, 21B, 22, 22B, R1 resistive element; 15, 16, 23, 23B, C1 capacitor; 17 analog semiconductor amplifier; 20 passive integration circuit (second integration circuit); 20B second passive integration circuit (third integration circuit); 30 digital circuit; 31, 31B differential input buffer element; 33, 33B buffer element for inverted output; 32, 32B D flip-flop; 34 signal generation circuit; 34B second signal generation circuit; 35 low pass filter; 36 difference detection circuit; 37, 137 selection circuit; 42 digital controller (feedback control unit); 43 subtractor; 44 compensator; 45 comparator; 46 carrier wave oscillator; 50 communication path; 60 power conversion circuit; 62 power semiconductor element; 63 diode; 64 inductor; 65 input capacitor; 66 output capacitor; 90, 92 ΔΣ type A/D converter; 91 first ΔΣ modulator; 91B second ΔΣ modulator; 93 A/D conversion system; 94 first ΔΣ type A/D converter; 194 second ΔΣ type A/D converter; 200 digital control power supply; 201 digital control device; 300 ΔΣ modulator; 310, 320 integrator; 311, 321 adder; 331 1-bit quantizer; 332 delay unit; 333 output inverting buffer element; 334 digital/analog converter; CLK clock signal; DS, DSB, Dout digital signal; FS fault sensing signal; GND ground; OCV output command value; V2, V4, V7 feedback voltage; V3, V6 output voltage; Vref reference voltage; Vth threshold voltage.

**Claims**

1. An analog/digital converter comprising:

    a first integration circuit to temporally integrate a sum of an analog input signal and a first feedback signal, the first integration circuit comprising an active element;
    a second integration circuit to temporally integrate a sum of a result of integration by the first integration circuit and the first feedback signal, the second integration circuit not comprising an active element; and
    a first signal generation circuit to compare a first output voltage representing a result of integration by the second integration circuit with a threshold voltage at discrete time intervals, the first signal generation circuit generating 1 as a first digital signal when the first output voltage is higher than the threshold voltage and generating 0 as the first digital signal when the first output voltage is lower than the threshold voltage, the first signal generation circuit outputting a signal obtained by inversion of 1 and 0 of the first digital signal as the first feedback signal.

2. The analog/digital converter according to claim 1, further comprising:

    a third integration circuit to temporally integrate a sum of the analog input signal and a second feedback signal, the third integration circuit not comprising an active element;
    a second signal generation circuit to compare a second output voltage representing a result of integration by the third integration circuit with the threshold voltage at discrete time intervals, the second signal generation circuit generating 1 as a second digital signal when the second output voltage is higher than the threshold voltage and generating 0 as the second digital signal when the second output voltage is lower than the threshold voltage, the second signal generation circuit outputting a signal obtained by inversion of 1 and 0 of the second digital signal as the second feedback signal; and
    a difference detection circuit to output a fault sensing signal when a difference between a time average of the first digital signal and a time average of the second digital signal is equal to or larger than a threshold value.

3. An analog/digital conversion system comprising:

    a first converter and a second converter each configured as the analog/digital converter according to claim 2;
    a first selection circuit to select whether to output the first digital signal to outside, the first digital signal being a result of A/D conversion of the analog input signal by the first converter; and
    a second selection circuit to select whether to output the first digital signal to the outside, the first digital signal being a result of A/D conversion of the analog input signal by the second converter, wherein
    when the fault sensing signal is outputted from the difference detection circuit of the first converter while the first digital signal is being outputted from the first converter to the outside, the first selection circuit stops output of the first digital signal from the first converter and notifies the second selection circuit that the first digital signal is to be outputted from the second converter.

4. An analog/digital conversion system comprising:

a first converter configured as the analog/digital converter according to claim 2; and

a second converter comprising the first integration circuit, the second integration circuit, and the first signal generation circuit and not comprising the third integration circuit, the second signal generation circuit, and the difference detection circuit, wherein

the first converter is provided in a signal path where a single point of failure may occur, and the second converter is provided in a signal path where a single point of failure may not occur.

5. The analog/digital converter according to claim 2, wherein

at least a part of a digital circuit comprising the first signal generation circuit, the second signal generation circuit, and the difference detection circuit is implemented by a programmable logic device or a microprocessor.

6. A digital control device comprising:

the analog/digital converter according to claim 2; and

a feedback control unit to generate an operation signal based on a difference between the first digital signal and an output command value.

7. A digital control power supply comprising:

the digital control device according to claim 6; and

a power conversion circuit comprising a semiconductor switching element controlled in accordance with the operation signal, wherein a voltage or a current outputted from the power conversion circuit is used as the analog input signal.

FIG.1

FIG.2

EP 4 489 308 A1

FIG.3

EP 4 489 308 A1

FIG.4

# FIG.5

EP 4 489 308 A1

## INTERNATIONAL SEARCH REPORT

| International application No. |
|---|
| **PCT/JP2022/009122** |

**A. CLASSIFICATION OF SUBJECT MATTER**

*H03M 1/08*(2006.01)i; *H03M 3/02*(2006.01)i
FI: H03M1/08 A; H03M3/02

According to International Patent Classification (IPC) or to both national classification and IPC

**B. FIELDS SEARCHED**

Minimum documentation searched (classification system followed by classification symbols)

H03M1/08; H03M3/02

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | US 2005/0116850 A1 (HEZAR, Rahmi et al.) 02 June 2005 (2005-06-02)<br>  paragraphs [0011]-[0022], fig. 2 | 1 |
| A | | 2-7 |
| Y | US 2005/0237233 A1 (TEXAS INSTRUMENTS INC.) 27 October 2005 (2005-10-27)<br>  paragraphs [0019]-[0031], fig. 2 (b) | 1 |
| A | | 2-7 |
| A | JP 2019-57937 A (DIAMOND ELECTRIC MFG. CO., LTD.) 11 April 2019 (2019-04-11)<br>  entire text, all drawings | 2-7 |
| A | JP 2002-369503 A (SHINDENGEN ELECTRIC MANUFACTURING CO., LTD.) 20 December 2002 (2002-12-20)<br>  entire text, all drawings | 6–7 |
| A | JP 63-248222 A (NIPPON TELEGRAPH AND TELEPHONE CORP.) 14 October 1988 (1988-10-14)<br>  entire text, all drawings | 1-7 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **10 May 2022** | **24 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

# EP 4 489 308 A1

**INTERNATIONAL SEARCH REPORT**

| | International application No. |
|---|---|
| | **PCT/JP2022/009122** |

**C.     DOCUMENTS CONSIDERED TO BE RELEVANT**

| Category* | Citation of document, with indication, where appropriate, of the relevant passages | Relevant to claim No. |
|---|---|---|
| A | JP 9-510056 A (ECHELON CORP.) 07 October 1997 (1997-10-07)<br>entire text, all drawings | 1-7 |

Form PCT/ISA/210 (second sheet) (January 2015)

17

**INTERNATIONAL SEARCH REPORT**
Information on patent family members

International application No.

**PCT/JP2022/009122**

| Patent document cited in search report | | | Publication date (day/month/year) | Patent family member(s) | Publication date (day/month/year) |
|---|---|---|---|---|---|
| US | 2005/0116850 | A1 | 02 June 2005 | (Family: none) | |
| US | 2005/0237233 | A1 | 27 October 2005 | WO 2008/115166 A1 paragraphs [0017]-[0029], fig. 2b | |
| JP | 2019-57937 | A | 11 April 2019 | (Family: none) | |
| JP | 2002-369503 | A | 20 December 2002 | US 2002/0185995 A1 entire text, all drawings EP 1265343 A2 | |
| JP | 63-248222 | A | 14 October 1988 | (Family: none) | |
| JP | 9-510056 | A | 07 October 1997 | US 5471209 A entire text, all drawings WO 1995/024077 A1 EP 1345330 A2 | |

Form PCT/ISA/210 (patent family annex) (January 2015)

**EP 4 489 308 A1**

**Patent documents cited in the description**

- JP 2019057937 A